# EUROPEAN PATENT APPLICATION

(11) **EP 1 624 568 A1**
(43) Date of publication of application: **08.02.2006**
(21) Application number: 05107105.8
(22) Date of filing: 01.08.2005
(51) Int. Cl.: H03K 5/24

(54) **Symmetrical pulse signal generator**

(30) Priority: 05.08.2004 DE 102004038101
(71) Applicant: TEXAS INSTRUMENTS DEUTSCHLAND GMBH, 85356 Freising (DE)
(72) Inventor: WIcht, Bernhard, 80798 Munich (DE); Remmers, Robert, 84032 Altdorf (DE); Baldwin, David J., Allen, TX 75002 (US)
(74) Representative: Holt, Michael

(57) **Abstract**

An improved pulse signal generator for generating a pulse signal (12) having highly symmetrical positive and negative pulses with respect to a reference level in response to a differential input voltage (VIN), the level of which determines the levels of the positive and of the negative pulses. The pulse signal generator comprises a signal output (26), a pulse amplifier (46) with differential inputs (INP, INN) and differential outputs (48, 50), the input voltage being applied to the differential inputs, and a common-mode feedback circuit (CMFB). The pulse signal generator further includes a buffer amplifier (MOUTP, MOUTN). The buffer amplifier has first and second inputs (56, 58) and first and second outputs (OUTP, OUTN), each of the first and second inputs being functionally connected to a different one of the differential outputs of the pulse amplifier. A pair of matched resistors (R1, R2) is connected in series between the first and second outputs (OUTP, OUTN) of the buffer amplifier to provide a reference level (OUTM). A switch (18) connects the signal output (26) selectively to one of the first and second outputs (OUTP, OUTN) of the buffer amplifier or to the reference level (OUTM).

## Description

### FIELD OF THE INVENTION

The present invention relates to a signal generator, and, more particularly, to a pulse signal generator for generating a pulse signal having symmetrical positive and negative pulses with respect to a reference level, the levels of the positive and of the negative pulses being determined in response to the level of a differential input voltage.

### BACKGROUND OF THE INVENTION

Some applications need highly symmetrical test pulses to verify proper operation. A pulse signal generator for generating a pulse signal that has symmetrical positive and negative pulses with respect to a reference level requires a symmetrical, dual voltage source that supplies voltages of the same level, but opposite signs, with respect to the reference level. In addition, the level of both voltages must be controllable by an input voltage which is either a programmed control voltage or has a certain temperature behavior. Thus, a differential input voltage is converted into a pair of voltages that are symmetrical with respect to the reference level.

Conventional circuits that supply symmetric voltage levels use a pulse amplifier with differential inputs and differential outputs, and with a common-mode feedback loop to adjust each of the symmetric voltage levels with respect to the reference level, or the reference voltage level with respect to each of the symmetric voltage levels. However, due to the finite gain of the common-mode feedback circuit, there is always some deviation from an ideal symmetry. While more sophisticated feedback circuits can alleviate the problem, they require a large silicon area (in the usual integrated circuit implementation, e.g., a CMOS implementation), and they are challenging in terms of stability, output swing, etc.

### SUMMARY OF THE INVENTION

The present invention provides an improved pulse signal generator for generating a pulse signal having highly symmetrical positive and negative pulses with respect to a reference level, in response to a differential input voltage whose level determines the levels of the positive and of the negative pulses.

A described pulse signal generator comprises a signal output, a pulse amplifier with differential inputs and differential outputs, the input voltage being applied to the differential inputs, and a common-mode feedback circuit. A buffer amplifier is also included. The buffer amplifier has first and second inputs and first and second outputs, each of the first and second inputs being functionally connected to a different one of the differential outputs of the pulse amplifier and a pair of matched resistors being connected in series between the first and second outputs of the buffer amplifier. A switch connects the signal output selectively to one of the first and second outputs of the buffer amplifier or to an interconnection node of the pair of matched resistors.

In one aspect of the invention, the symmetry between the positive and negative output levels (with respect to the common reference level) depends only on the matching of the two resistors. As the resistors are connected in series and the same current must flow through both resistors, any limitation in the gain of the common-mode feedback loop does not influence the symmetry of the voltage drops across the resistors. Accordingly, the symmetry is ensured by the matching of two resistors in the buffer stage only, and symmetry is not affected by other influences. The described pulse generator is robust and is easily implemented in a CMOS integrated circuit. It works over a wide range of pulse levels to be generated, e.g., from less than 100 mV to several Volts.

In a preferred embodiment of the invention, the interconnection node of the two matched resistors is used not only as a center tap for the reference voltage level, but also as an input to the common-mode feedback loop. Specifically, the interconnection node of the matched resistors is a reference output that supplies the reference level. The first output of the buffer amplifier supplies the level of the positive pulses and the second output of the buffer amplifier supplies the level of the negative pulses. Preferably, the common-mode feedback circuit has a differential input stage with a first input connected to a set reference source and a second input connected to the reference output.

In a preferred CMOS integrated circuit implementation, the differential input stage of the common-mode feedback circuit includes a split transistor pair with interconnected gates and sources, jointly forming a first differential input transistor device, and a second differential input transistor device. A first transistor of the split transistor pair has a drain connected to a first one of the differential outputs of the pulse amplifier, and a second transistor of the split transistor pair has a drain connected to a second one of the differential outputs of the pulse amplifier. This avoids a third pole in the feedback loop and ensuing problems in terms of stability.

According to another aspect of the invention, the buffer amplifier is a class AB amplifier. When the pulse signal generator is implemented in a CMOS integrated circuit technology, a level shifter is inserted between each of the first and second inputs of the buffer amplifier and a corresponding differential output of the pulse amplifier. Although the pulse signal generator does include a buffer amplifier, a load current at the reference level output may have some influence, and an extra buffer may be required for some applications.

### BRIEF DESCRIPTION OF THE DRAWINGS

Further advantages and features of the invention will become apparent from the following description with reference to the accompanying drawings, wherein:
FIG. 1 illustrates a pulse signal having symmetrical positive and negative pulses with respect to a reference level;
FIG. 2 is a circuit diagram of a symmetric pulse signal generator;
FIG. 3 (Prior Art) is circuit diagram of a conventional symmetric pulse signal generator;
FIG. 4 is a circuit diagram of a symmetric pulse signal generator in accordance with the principles of the invention;
FIG. 5 is a detailed circuit diagram of an embodiment of a symmetrical dual voltage source circuit with common-mode feedback for use in the pulse signal generator of FIG. 4; and
FIG. 6 (Prior Art) is an explanatory partial circuit diagram illustrating a conventional approach with a three-pole feedback loop.

### DETAILED DESCRIPTION OF EMBODIMENTS

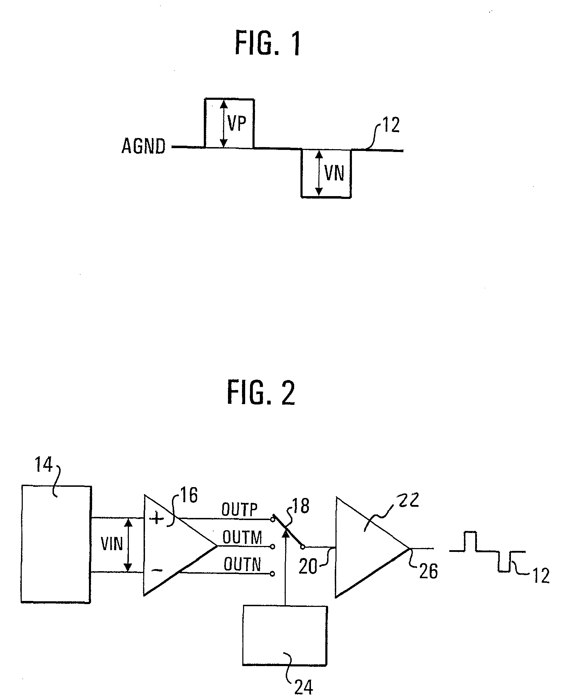

Referring to FIG. 1, an illustrated pulse signal 12 consists of symmetric positive voltage level. The positive pulses have a relative voltage level VP and the negative pulses have a relative voltage level VN. The positive and negative pulses are shown separated by an intermediate signal condition, wherein the output signal is at the analog ground voltage level of set reference source AGND. As is readily apparent, when the absolute values of VP and VN are not identical for any reason, an asymmetry is calculated by |VP-VN| / ((VP+VN) / 2).

In FIG. 2, a voltage control block 14 supplies an input voltage VIN to differential inputs of a pulse amplifier 16 that has a first output OUTP supplying the positive output level VP, a second output OUTN supplying the negative output level VN, and a third output OUTM supplying the analog ground voltage level of set reference source AGND. A switch 18 selectively connects an input 20 of a buffer amplifier 22 to one of the outputs OUTP, OUTN and OUTM under control of a switch control circuit 24. Pulse signal 12 is output at a signal output 26 of buffer amplifier 22. As shown, pulse signal 12 has symmetric positive and negative pulses with relative voltage levels VP and VN respectively and an analog ground voltage level AGND.

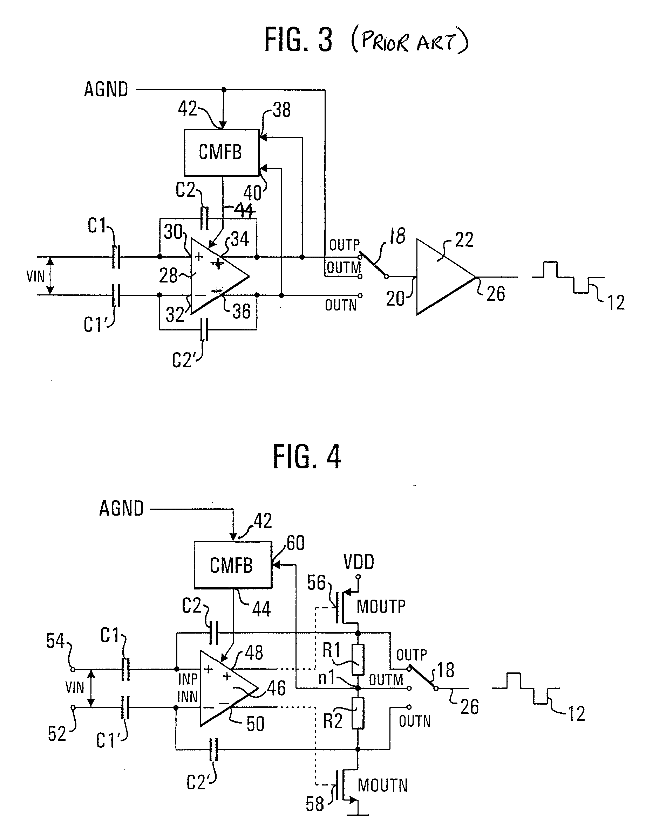

A conventional pulse signal generator, as illustrated in FIG. 3, comprises two voltage input terminals and a pulse amplifier 28 with differential inputs 30, 32 and differential outputs 34, 36 in a feedback configuration. A feedback network is formed by two capacitors C2, C2'. One capacitor C2 is connected between differential output 34 and differential input 30 of pulse amplifier 28, and the other capacitor C2' is connected between differential output 36 and differential input 32. Two capacitors Cl, Cl' are each connected between one of differential inputs 30, 32 of pulse amplifier 28 and a respective voltage input terminal. A differential voltage VIN is applied between the two voltage input terminals. As known to a person skilled in the art, capacitors C1 and C2 define the output voltages VP, VN at the differential outputs 34, 36 of pulse amplifier 28 according to the equation: VP, VN = AGND +/- C1/C2 * VIN/2.

The conventional pulse signal generator further comprises a common-mode feedback circuit CMFB with two inputs 38, 40 respectively connected to the two differential outputs 34, 36 of pulse amplifier 28, and an input 42 connected to a set reference source AGND. Common-mode feedback circuit CMFB has an output 44 connected to a control input of pulse amplifier 28. Thus, output voltages VP, VN are used as feedback voltages, with the set reference source AGND being another input to common-mode feedback circuit CMFB.

The pulse signal generator has three outputs OUTP, OUTM and OUTN, and further comprises a switch 18 and a buffer amplifier 22 with an input 20 and an output 26. Output voltage VP is applied to output OUTP, output voltage VN is applied to output OUTN, and the analog ground voltage of set reference source AGND is applied to output OUTM. As explained with reference to FIG. 2, switch 18 selectively connects input 20 of buffer amplifier 22 to one of the outputs OUTP, OUTN and OUTM. Buffer amplifier 22 outputs a pulse signal 12 at signal output 26.

In the conventional pulse signal generator of FIG. 3, the symmetry between the two pulse voltage levels VP and VN depends mainly on the matching of capacitors C1 and C2 and on the common-mode feedback circuit CMFB as it controls voltage levels VP and VN with respect to the analog ground voltage of set reference source AGND. Due to the finite gain of common-mode feedback circuit CMFB, there is always some deviation between the analog ground voltage and a calculated reference voltage level (VP+VN)/2, causing an increased pulse asymmetry. In the conventional approach of FIG. 3, it is also possible to use feedback resistors instead of capacitors C1 , C1' and C2, C2'.

A symmetric pulse signal generator in accordance with a generic embodiment of the invention is shown in FIG. 4. The illustrated generator comprises a pulse amplifier 46 with two differential inputs INN and INP and two differential outputs 48, 50. It further comprises two control voltage input terminals 52 ,54 , two capacitors Cl, Cl' , a feedback network with two capacitors C2, C2' and a buffer amplifier. The buffer amplifier of FIG. 4 has a PMOS field effect transistor MOUTP, two matched resistors R1, R2, and an NMOS field effect transistor MOUTN, all connected in series between a voltage supply terminal VDD and ground. The pair of matched resistors R1, R2 is connected in series between the drains of transistors MOUTP and MOUTN. The source of transistor MOUTP is connected to the voltage supply terminal VDD and the source of transistor MOUTN is connected to ground. The gate of transistor MOUTP forms a first input 56 and the gate of transistor MOUTN forms a second input 58 of the buffer amplifier. The drain of transistor MOUTP is connected to a first output OUTP of the buffer amplifier and the drain of transistor MOUTN is connected to a second output OUTN of the buffer amplifier. Thus, resistors R1 and R2 are connected in series between the first output OUTP and the second output OUTN. An interconnection node nl between the two resistors RI and R2 is connected to a reference output OUTM.

Control voltage input terminal 52 is connected via a first capacitor Cl' to differential input INN, while control voltage input terminal 54 is connected via a second capacitor Cl to differential input INP. Each of the differential outputs 48, 50 of pulse amplifier 46 is functionally connected to a different one of the first and the second inputs of the buffer amplifier. As they are not connected directly, the connection is shown in FIG. 4 as a dashed line. More specifically, differential output 48 is functionally connected to input 56 and differential output 50 to input 58. A first capacitor C2 is connected between the drain of transistor MOUTP and differential input INP of pulse amplifier 46 and a second capacitor C2' is connected between the drain of transistor MOUTN and differential input INN of pulse amplifier 46. As in FIG. 3 capacitors C2 and C2' form a feedback network.. The illustrated inventive circuit further comprises a common-mode feedback circuit CMFB which has an input 42 connected to a set reference source AGND. An output 44 of common-mode feedback circuit CMFB is connected to a control input of pulse amplifier 46 and an input 60 is connected to interconnection node nl and thus to reference output OUTM. A switch 18 connects a signal output 26 selectively to one of the first and second outputs OUTN, OUTP of the buffer amplifier or to reference output OUTM.

In operation, a voltage VIN is applied between the two voltage input terminals 52 and 54. As in the conventional approach, input voltage VIN defines the pulse magnitude together with the external feedback and capacitive voltage divider which is realized by capacitors C1,C1' and C2, C2'. If the input voltage VIN increases, then the gate potentials of transistors MOUTP and MOUTN (and, therefore, the gate-source voltages of transistors MOUTP and MOUTN) change to turn the transistors more and more on. Thus, the current through resistors R1, R2 increases, causing a larger pulse magnitude. Output OUTP supplies a positive voltage level VP for positive pulses, and output OUTN supplies a negative voltage level VN for negative pulses. Reference output OUTM supplies a reference voltage level VM for the pulse signal. Reference voltage level VM depends in this configuration only on the matching of the two resistors R1 and R2. As it is relatively easy to provide a good match between resistors, this provides an extremely precise symmetry of the voltage levels VP and VN with respect to reference voltage level VM, even with regular matching of the feedback components and with a simple common-mode feedback circuit. The feedback voltage used for the common-mode feedback circuit CMFB in the illustrated inventive circuit embodiment is the reference voltage level VM at output OUTM, which is defined by the resistors R1 and R2 and by the voltages VP and VN. The shown pulse signal 12 output at signal output 26 consists of symmetrical positive and negative pulses with respect to reference voltage level VM.

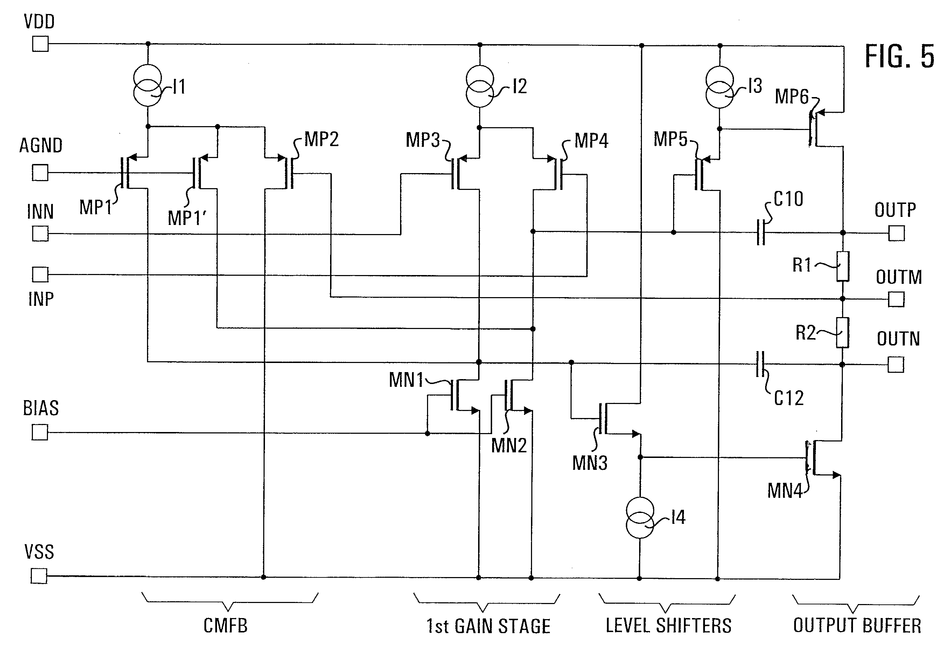

FIG. 5 shows details of an example implementation of a symmetrical dual voltage source circuit, which may form part of the inventive pulse signal generator shown in FIG. 4. Capacitors C1, C1' and C2, C2', as well as switch 18, of FIG. 4 may be external to the symmetrical dual voltage source circuit which comprises a common-mode feedback circuit, a first gain stage of a pulse amplifier, level shifters and an output buffer.

The common-mode feedback circuit CMFB is formed by three PMOS transistors MP1, MP1', MP2 and a current source 11. Transistors MP1, MP1' and MP2 are mounted to form a differential input stage, wherein split transistors MP1 and MP1' are of same size, have interconnected gates and sources and jointly constitute a first differential input transistor device. The second differential input transistor device is transistor MP2 which is twice the size of transistor MP 1 or MP1'. The source of transistor MP2 is connected to the sources of transistors MP1 and MP 1' and to current source I1. The interconnected gates of transistors MP 1 and MP 1' are connected to set reference source AGND, while the gate of transistor MP2 is connected to a reference output OUTM via an interconnection node nl. Thus, common-mode feedback circuit CMFB has a differential input stage with a first input connected to set reference source AGND and with a second input connected to reference output OUTM. The current source I1 is connected to voltage supply terminal VDD. The drain of transistor MP2 is connected to voltage supply terminal VSS.

The symmetrical dual voltage source circuit further provides two inputs INN and INP which are connected to the first gain stage. The first gain stage comprises two PMOS transistors MP3, MP4, two NMOS transistors MN1, MN2 and a current source I2. Input INN is connected to the gate of transistor MP3, while input INP is connected to the gate of transistor MP4. Transistors MP3 and MP4 are interconnected at their sources and connected with their sources to current source I2. They form a differential transistor pair of the first gain stage. The drain of transistor MP3 is connected to the drain of transistor MN1, while the drain of transistor MP4 is connected to the drain of transistor MN2. Transistors MN1 and MN2 form the load of differential transistor pair MP3 and MP4 and are biased at their gates by a voltage source BIAS. Transistors MN1 and MN2 are connected with their respective sources to voltage supply terminal VSS. Transistor MP1 of the split transistor pair MP 1, MP 1' of common-mode feedback circuit CMFB has its drain connected to the drain of transistor MN1 and transistor MP1' of the split transistor pair MP1, MP1' is connected with its drain to the drain of transistor MN2. The first gain stage provides two differential outputs. A first differential output is formed by the drain of transistor MP4 and a second differential output is formed by the drain of transistor MP3. Thus, the outputs of the first gain stage of the pulse amplifier are connected to the common-mode feedback circuit CMFB.

The outputs of the first gain stage are connected to the inputs of the buffer stage through level shifters. The level shifters comprise a PMOS transistor MP5, an NMOS transistor MN3 and two current sources I3 and 14. One differential output, the drain of transistor MP3, is connected to the gate of NMOS transistor MN3. The other differential output, the drain of transistor MP4, is connected to the gate of transistor MP5. The drain of transistor MN3 is connected to voltage supply terminal VDD and the source of transistor MN3 is connected to current source I4 which is connected to voltage supply terminal VSS. The drain of transistor MP5 is connected to voltage supply terminal VSS and the source of transistor MP5 is connected to current source 13 which is connected with its other side to voltage supply terminal VDD. The level shifters provide two outputs. A first output is formed by the source of transistor MN3 and a second output is formed by the source of transistor MP5.

The outputs of the level shifters are connected to inputs of the output buffer. The output buffer is formed by a PMOS transistor MP6, an NMOS transistor MN4 and two matched resistors R1 and R2. The first output of the level shifters, the source of transistor MN3, is connected to the gate of transistor MN4. The second output of the level shifters, the source of transistor MP5, is connected to the gate of transistor MP6. The source of transistor MN4 is connected to voltage supply terminal VSS. The source of transistor MP6 is connected to voltage supply terminal VDD. Resistors R1 and R2 are connected in series between the drain of transistor MP6 and the drain of transistor MN4. A first output OUTP is connected to the drain of transistor MP6 and a second output OUTN is connected to the drain of transistor MN4. The interconnection node nl between resistors RI and R2 is connected to reference output OUTM.

Connecting the level shifters between the first gain stage and the output buffer establishes a class AB biasing of the output buffer. In FIG. 4, the level shifters required for a class AB biasing were indicated by dashed lines between the differential outputs of the pulse amplifier and the gates of output transistors MOUTP and MOUTN.

In the symmetrical dual voltage source circuit of FIG. 5 a capacitor C10 is connected for frequency compensation between the first output OUTP of the buffer amplifier and the corresponding input of the level shifters, the gate of transistor MP5, while a capacitor C12 is connected between the second output OUTN of the buffer amplifier and the corresponding input of the level shifters, the gate of transistor MN3.
In a preferred implementation, current sources I1, I2, I3 and I4 are all realized as current mirrors of a single current source (not shown in FIG. 5).

In operation, a voltage VIN is applied between input INN and input INP. This voltage is amplified in the first gain stage of the pulse amplifier. As is known in the art, the amplification depends on the parameters of transistors MP3 and MP4, the current supplied by current source I2 and the biasing of load transistors MN1 and MN2. The first gain stage outputs an amplified voltage difference between the drain of transistor MP3 and the drain of transistor MP4. The voltage levels at the drains of transistors MP3 and MP4 are output to the level shifters formed by transistor MP5 and current source I3 and by transistor MN3 and current source 14. These level-shifted voltages are then respectively applied to the gates of transistors MP6 and MN4 of the output buffer. Thus, an increase of voltage VIN has a direct effect on current flow through transistors MP6 and MN4. With an increasing voltage VIN, the gate-source voltages at transistors MP6 and MN4 increase, thereby opening the transistors more and more. With transistors MP6 and MN4 more open, more current flows through resistors R1 and R2. A higher current through resistors R1, R2 causes a larger pulse magnitude to occur. Therefore, the pulse magnitude depends on the applied input voltage VIN. In an actual implementation, as shown in FIG. 4, the pulse magnitude is eventually defined by an external feedback. At output OUTP the positive voltage level VP is provided and at output OUTN the negative voltage level VN is provided. At reference output OUTM a reference voltage VM is provided. Reference voltage VM is defined by the resistive divider formed by matched resistors R1 and R2. Since it is relatively easy to provide a good match between resistors, the matching of resistors R1, R2 ensures the symmetry of the output pulses.

Reference voltage VM at reference output OUTM is fed back to common-mode feedback circuit CMFB; and, more specifically, to the gate of transistor MP2. The analog ground voltage of set reference source AGND is applied on the gates of the split transistors MP1 and MP1', which form a differential transistor pair together with transistor MP2. The voltage difference sensed between the analog ground voltage and reference voltage VM leads to identical currents through transistor MP1 and through transistor MP 1' which are fed to load transistors MN1 and MN2 of the first gain stage. As the drains of transistors MP1 and MP1' are connected to the drains of load transistors MN1, MN2 of the first gain stage, respectively, the current flowing through transistor MP1 is added to the current flowing through transistor MP3, and the current flowing through transistor MP1' is added to the current flowing through transistor MP4. Thus, the current flowing through transistor MN1 is the sum of the current through transistor MP1 and the current through transistor MP3, while the current which flows through transistor MN2 is the sum of the current flowing through transistor MP1' and the current flowing through transistor MP4. Common-mode feedback circuit CMFB which is integrated in the inventive circuit as shown in FIG. 5 realizes a two-pole feedback loop with a first pole at the drain of transistor MN2 and a second pole at the gate of transistor MP2. The two-poled feedback loop shares the frequency compensation (capacitor C10 and capacitor C12) with the signal path. The proposed common-mode feedback circuit is easy to implement and small in area since it uses the frequency compensation and load transistors of the signal path.

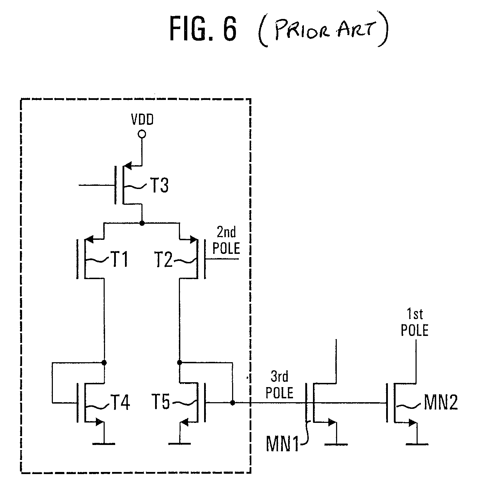

By contrast, FIG. 6 shows an implementation with a conventional common-mode feedback circuit. The differential transistor pair T1 and T2 is used to sense a voltage difference. This transistor pair T1 and T2 is interconnected at its sources and connected to the drain of a transistor T3 the source of which is connected to a voltage supply terminal VDD. The drain of transistor T1 is connected to the drain of a transistor T4 which is connected with its source to ground and has its gate and its drain interconnected. The drain of transistor T2 is connected to the drain of a transistor T5 which forms with transistor T4 a transistor pair. The source of transistor T5 is connected to ground, gate and drain of transistor T5 are interconnected.

In this conventional circuit, the gate of transistor T5 is connected to the gates of transistors MN1 and MN2, which are the load transistors of the first gain stage in FIG. 5. This connection forms a third pole of the feedback loop. The first pole is the drain of transistor MN2, as in the above described inventive circuit embodiments, and the second pole is the gate of transistor T2, which corresponds to the second pole at the gate of transistor MP2 in FIG. 5.

The common-mode feedback circuit as used in the inventive circuit in FIG. 5 has only two poles. By splitting one of the transistors of the differential transistor pair of the common mode feedback circuit into two transistors MP1 and MP1', the identical currents flowing through these transistors can be fed to the drains of transistors MN1 and MN2. The gates of transistors MN1 and MN2 are no longer connected to the feedback circuit as in the conventional approach but biased independently. A feedback regulation circuit with only two poles can be much more stable than a feedback loop with three poles.

## Claims

1. A circuit for generating a pulse signal (12) having symmetrical positive and negative pulses with respect to a reference level, the levels (VP, VN) of the positive and negative pulses being determined in response to the level of a differential input voltage (VIN), the circuit comprising:
a signal output (26);
a pulse amplifier (46) having two differential inputs (INN, INP) to which the input voltage is applied, a control input (44), and two differential outputs (48, 50);
a common-mode feedback circuit (CMFB) having a first input (42) connected to a reference source (AGND), a second input (60), and an output connected to the control input (44) of the pulse amplifier;
a buffer amplifier (MOUTP, MOUTN) having first and second inputs(56, 58) and first and second outputs (OUTP, OUTN), each of the first and second inputs being functionally connected to a different one of the differential outputs (48, 50) of the pulse amplifier (46); and
a pair of matched resistors (R1, R2) connected in series between the first and second outputs (OUTP, OUTN) of the buffer amplifier; an interconnection node .(n1) of the pair of matched resistors (R1, R2) being coupled to the second input (60) of the common-mode feedback circuit (CMFB); and
a switch (18) selectively connecting one of the first and second outputs (OUTP, OUTN) of the buffer amplifier or the interconnection node (n1) to the signal output.

2. The circuit of claim 1, wherein the interconnection node of the pair of matched resistors (R1, R2) is a reference output (OUTM) that supplies the pulse signal reference level, the first output (OUTP) of the buffer amplifier supplies the level of the positive pulses and the second output (OUTN) of the buffer amplifier supplies the level of the negative pulses.

3. The circuit of claim 2, wherein the common-mode feedback circuit (CMFB) has a differential input stage with a first input connected to a set reference source (AGND) and a second input connected to the reference output (OUTM).

4. The circuit according to any of claims 1 to 3, wherein the buffer amplifier is a class AB amplifier.

5. The circuit of claim 4, implemented in a CMOS integrated circuit technology and comprising a level shifter coupled between each of the first and second outputs (56, 58) of the buffer amplifier and a corresponding differential output (48, 50) of the pulse amplifier.

6. The pulse signal generator according to any of claims 3 to 5, implemented in a CMOS integrated circuit technology,
wherein a differential input stage of the common-mode feedback circuit (CMFB) includes a split transistor pair (MP1, MP1') with interconnected gates and sources and jointly forming a first differential input transistor device, and a second differential input transistor device (MP2);
wherein the pulse amplifier includes a load transistor pair (MN1, MN2) with interconnected gates, and
wherein a first transistor (MP1) of the split transistor pair (MP1, MP1') has a drain connected to a drain of a first transistor (MN1) of the load transistor pair (MN1, MN2) and a second transistor (MP1') of the split transistor pair (MP1, MP1') has a drain connected to a drain of a second transistor (MN2) of the load transistor pair (MN1, MN2).

7. The pulse signal generator according to any preceding claim, wherein a frequency compensation capacitor (C10, C12) is connected between each of the first and second outputs (OUTP, OUTN) of the buffer amplifier and a corresponding level shifter input.
